# EUROPEAN PATENT APPLICATION

(11) **EP 1 533 855 A1**
(43) Date of publication of application: **25.05.2005**
(21) Application number: 04027315.3
(22) Date of filing: 17.11.2004
(51) Int. Cl.: H01L 51/40, H01L 21/20, C25D 3/00, G02F 1/167

(54) **Thin film transistor, method for its manufacture, and circuit or electronic device/apparatus comprising it**

(30) Priority: 19.11.2003 JP 2003390001
(71) Applicant: Seiko Epson Corporation, Shinjuku-ku, Tokyo 163-0811 (JP)
(72) Inventor: Kawase, Takeo, Suwa-shi, Nagano-ken 392-8502 (JP); Harada, Mitsuaki, Suwa-shi, Nagano-ken 392-8502 (JP); Kimura, Satoshi, Suwa-shi, Nagano-ken 392-8502 (JP); Furihata, Hidemichi, Suwa-shi, Nagano-ken 392-8502 (JP)
(74) Representative: HOFFMANN - EITLE

(57) **Abstract**

The invention provides a method of manufacturing a thin film transistor capable of manufacturing a high-performance thin film transistor with a simple process, which comprises the steps of
(i) forming a source electrode (3) and a drain electrode (4) on a substrate (2) by an electroless plating process,
(ii) forming an organic semiconductor layer (5) in at least an area between the source electrode (3) and the drain electrode (4) using a coating method,
(iii) forming a gate-insulating layer (6) on the organic semiconductor layer (5) using a coating method, and
(iv) forming a gate electrode (7) using a coating method so as to overlap an area on the gate-insulating layer (6) and between the source electrode (3) and the drain electrode (4).

Also, the invention provides for a thin film transistor obtainable according to the above method, and a thin film transistor circuit, an electronic device, and an electronic apparatus each equipped with the thin film transistor.

## Description

### Field of the Invention

The present invention relates to a method of manufacturing a thin film transistor, a thin film transistor, a thin film transistor circuit, an electronic device, and an electronic apparatus.

### Background

In recent years, thin film transistors using organic materials (organic semiconductor materials) presenting electrically conductive properties similar to semiconductors are under development. The thin film transistors have advantages of good adaptability to low-profile and weight-saving, flexibility, low material cost and so on, and expected to realize switching elements for flexible displays or the like.

As such thin film transistors, a structure is proposed in e.g. JP-A-5-55568 ("JP-A-" stands for a Japanese Unexamined Patent Application Publication), WO01/47045 and WO01/47043 in which a source electrode and a drain electrode are formed on a substrate with an organic semiconductor layer, a gate-insulating layer, and a gate electrode stacked on these electrodes in this order.

JP-A-5-55568 discloses that a vacuum deposition method is used for forming a gate electrode, a source electrode, and a drain electrode.

By forming an insulating layer and an organic semiconductor layer using the vacuum deposition method in addition to forming the gate electrode, the source electrode, and the drain electrode using the vacuum deposition method as described therein, a high-performance thin film transistor can be manufactured with good reproducibility.

However, the vacuum deposition method requires a large-scale facility, and presents problems of high-cost and so on derived from large power consumption required to form the films.

WO01/47045 and WO01/47043 disclose that all of the gate electrode, the source electrode, drain electrode, the insulating layer, and the organic semiconductor layer are formed as films by a wet process under the atmospheric pressure. According to this, a thin film transistor can be manufactured with a low cost.

However, in the actual situation, the thin film transistors described in WO01/47045 and WO01/47043 have sufficient properties in comparison with thin film transistors manufactured by the vacuum deposition process.

### Disclosure of the Invention

The present invention is for providing a method of manufacturing a thin film transistor capable of manufacturing a high-performance thin film transistor with a simple process, a thin film transistor manufactured using the method of manufacturing a thin film transistor, and a thin film transistor circuit, an electronic device, and an electronic apparatus each equipped with the thin film transistor.

The object of the present invention described above is achieved by a method of manufacturing a thin film transistor comprising the steps of
(a) forming a source electrode and a drain electrode on a substrate by an electroless plating process,
(b) forming an organic semiconductor layer in at least an area between the source electrode and the drain electrode using a coating method,
(c) forming a gate-insulating layer on the organic semiconductor layer using a coating method, and
(d) forming a gate electrode using a coating method so as to overlap an area on the gate-insulating layer and between the source electrode and the drain electrode.

Thus, a thin film transistor with superior characteristics can be manufactured by a simple process.

It is preferable that in step (a) the source electrode and the drain electrode are selectively formed by providing an electroless plating solution inside an opening of a mask provided on the substrate. Thus, the further simplification of the manufacturing steps of a thin film transistor, reduction of the plating solution consumption, and so on can be achieved.

Also, it is preferable that in the step (a) a plating solution used for the electroless plating process includes a reducing agent and a metal salt of a metal for forming the source electrode and the drain electrode, and is substantially free of alkali metal ions. This gives rise to preferred characteristics of the organic semiconductor layer.

The content of the metal salt in the plating solution is preferably in a range of 1 through 50 g/L. Also, the reducing agent is preferably composed mainly of at least one of hydrazine and ammonium hypophosphite. These measures ensure that a preferred deposition rate of the plated film can be achieved, which makes it easy to control the thickness of the plated film.

The content of the reducing agent in the plating solution is preferably in a range of 10 through 200 g/L. This achieves that the plated film can be formed at an even further preferred deposition rate.

The plating solution preferably includes a pH adjuster, which helps to prevent or control that the pH of the plating solution is lowered as electroless plating proceeds, and as a result, a slow-down of the deposition rate or changes in composition or characteristics of the plated film can effectively be prevented.

More preferably, the pH adjuster is mainly composed of at least one of ammonia water, trimethyl ammonium hydride, and ammonium sulfide, to more safely prevent a slow-down of the deposition rate or changes in composition or characteristics of the plated film.

The pH of the plating solution used in the electroless plating process is preferably in a range of 5-12. Also, the temperature of the plating solution used in this process is preferably 30-90°C. If one or both of these requirements is/are met, the deposition rate becomes especially proper, and accordingly a more preferred plated film having an even thickness could be formed with high precision.

It is preferable that in the step (a) both of the source electrode and the drain electrode are formed like comb-teeth and arranged to engage with each other. Thus, the area of the section where the gate electrode overlaps the source electrode or the drain electrode can be prevented from increasing, and accordingly, the characteristics of the thin film transistor can further be enhanced.

Preferably, each of the source electrode and the drain electrode is mainly composed of one ofNi, Cu, Pd, Au, Pt, and an alloy including one ofNi, Cu, Pd, Au, and Pt, to achieve further enhanced and thus preferable characteristics of the thin film transistor.

Prior to the step (b), the present method preferably comprises a step of removing any organic matter existing in the side of the substrate surface where the organic semiconductor layer is to be formed. Thus, the adhesiveness of the source electrode and the drain electrode with the organic semiconductor layer can be enhanced.

To remove the organic matters safely in a short period of time, the organic matter is preferably removed by a plasma process.
More preferably, the plasma process is preferably executed under the atmospheric pressure to achieve low manufacturing costs and short cycle times in manufacturing. Also, if the plasma is generated using a gas composed mainly of at least one of oxygen, nitrogen, argon, helium, and fluorocarbon, simplified equipment can be because these gases can generate plasma in low vacuum atmosphere or under the atmospheric pressure.

The organic semiconductor layer preferably is mainly composed of a conjugated polymeric material. Such materials have particularly high carrier migratory aptitude because of characteristic distributions of the electron clouds. More preferably, the conjugated polymeric material is mainly composed of at least one of fluorene-bithiophene copolymer, polyarylamine, and derivatives thereof, which materials are difficult to be oxidized, and accordingly stable in air.

In the step (d), preferably an inkjet method is used as a coating method for forming the gate electrode, to surely obtain a gate electrode having a predetermined shape in an easy manner.

The gate electrode preferably is mainly composed of an electrically conductive polymeric material, and more preferably is formed from a fluid including metal particles. The metal particles preferably are mainly composed of Ag. Thus, the material for forming the gate electrode can easily be prepared, and further, high conductivity can be obtained in the resulting gate electrode.

The substrate of the thin film transistor of the present invention preferably is a resin substrate composed mainly of a resin material. In this case, the present method preferably comprises prior to the step (a) a step of conducting on the surface of the resin substrate where the source electrode and the drain electrode are to be formed an adhesiveness enhancing process for enhancing adhesiveness with the source electrode and the drain electrode. Thus, the thin film transistor characteristics can be further enhanced.

The adhesiveness enhancing process preferably comprises a step of etching the surface of the resin substrate with an etching fluid including a transition metal oxide and an inorganic acid, and a step of treating the surface with a treatment fluid including a reducing agent substantially free of an alkali metal element. Preferably, the reducing agent is mainly composed of an ammonium compound, which has a superior reduction performance, and more preferably the ammonium compound is ammonium sulfite hydrate. Thus, the adhesiveness enhancing process can be conducted while preventing the characteristics of the organic semiconductor layer from deteriorating.

With the method of the present invention a thin film transistor with superior characteristics (switching characteristics) can be obtained.

If the present thin film transistor is comprised in a thin film transistor circuit, which in turn may be comprised in an electronic device and/or an electronic apparatus, a thin film transistor circuit, an electronic device and an electronic apparatus with high reliability can be obtained.

### Brief Description of the Drawings

- FIG. 1:: FIGS. 1A and 1B are views showing the thin film transistor of the first configuration, in which FIG. 1A is a vertical cross-sectional view, and FIG. 1B is a plan view.
- FIG. 2:: FIGS. 2A-2C are vertical cross-sectional views explaining the second manufacturing method of the thin film transistor shown in FIGS. 1A and 1B.
- FIG. 3:: FIGS. 3D-3F are vertical cross-sectional views explaining the second manufacturing method of the thin film transistor shown in FIGS. 1A and 1B.
- FIG. 4:: FIGS. 4G-4J are vertical cross-sectional views explaining the second manufacturing method of the thin film transistor shown in FIGS. 1A and 1B.
- FIG. 5:: FIGS. 5A-5D are vertical cross-sectional views explaining the second manufacturing method of the thin film transistor shown in FIGS. 1A and 1B.
- FIG. 6:: FIGS. 6A and 6B are views showing the thin film transistor of the second configuration, in which FIG. 6A is a vertical cross-sectional view, and FIG. 6B is a plan view.
- FIG. 7:: FIG. 7 is a vertical cross-sectional view showing an embodiment of applying an electronic device according to the present invention to an electrophoretic display device.
- FIG. 8:: FIG. 8 is a block diagram showing a configuration of an active matrix device provided to the electrophoretic display device shown in FIG. 7.
- FIG. 9:: FIG. 9 is a perspective view showing an embodiment of applying the electronic apparatus according to the present invention to an electronic paper.
- FIG. 10:: FIGS. 10A and 10B are schematic views showing an embodiment of applying the electronic apparatus according to the present invention to a display.

In the drawings the reference numbers have the following meanings:
- 1, 11: thin film transistor
- 2: substrate
- 3: source electrode
- 3a: electrode finger
- 4: drain electrode
- 5: organic semiconductor
- 51: channel region
- 6: gate-insulating layer
- 7: gate electrode
- 8: plated film
- 9: resist layer
- 10: plating solution
- 20: electrophoretic display device
- 30: active matrix device
- 31: data line
- 32: scanning line
- 40: electrophoretic display
- 41: pixel electrode
- 42: microcapsule
- 420: electrophoretic dispersion liquid
- 421, 422: electrophoretic particle
- 43: transparent electrode
- 44: transparent substrate
- 45: binder member
- 50: substrate
- 600: electronic paper
- 601: main body
- 602: display unit
- 800: display
- 801: main body
- 802a, 802b: pair of feed rollers
- 803: hollow section
- 804: transparent glass plate
- 805: inlet
- 806: terminal section
- 807: socket
- 808: controller
- 809: operation section

### Preferred Embodiments

Detailed descriptions are presented herein based on preferred embodiments of a method of manufacturing a thin film transistor, a thin film transistor, a thin film transistor circuit, an electronic device, and an electronic apparatus according to the present invention.

### Thin Film Transistor and Method for its Manufacture

### First Configuration of the Thin Film Transistor

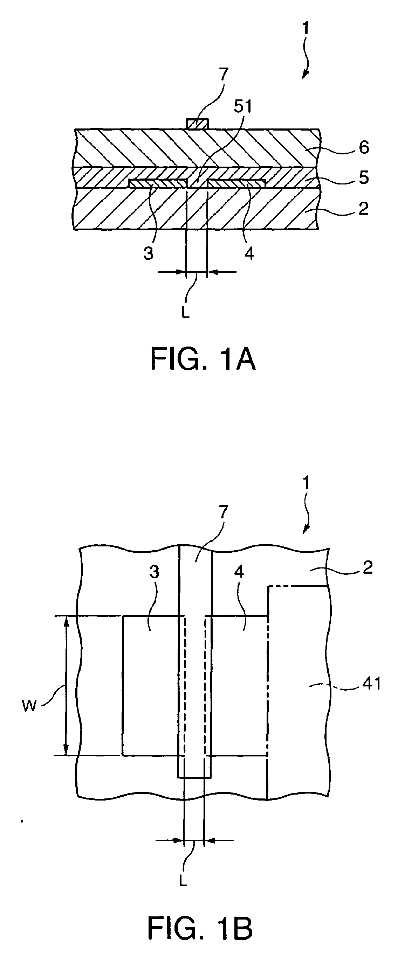

A first configuration (a first embodiment) of a thin film transistor according to the present invention is as shown in FIG.1, in which FIG. 1A is a vertical cross-sectional view, and FIG. 1B is a plan view. Note that the upper side of FIG. 1A is referred to as "upper side" and the lower side thereof is referred to as "lower side" in the following descriptions.

A thin film transistor 1 shown in FIGS. 1A and 1B is provided on a substrate 2, and is composed of a source electrode 3, a drain electrode 4, an organic semiconductor layer (an organic layer) 5, a gate-insulating layer 6, and a gate electrode 7 stacked on the substrate 2 in this order.

Specifically, the thin film transistor 1 is provided on the substrate 2 so that the source electrode 3 and the drain electrode 4 are separated, and the organic semiconductor layer 5 is provided so as to cover the electrodes 3 and 4. Further, the gate-insulating layer 6 is provided on the organic semiconductor layer 5, on which the gate electrode 7 is provided so as to overlap at least an area between the source electrode 3 and the drain electrode 4.

In the thin film transistor 1, a part of the organic semiconductor layer 5 positioned between the source electrode 3 and the drain electrode 4 is defined as a channel region 51 through which carriers are transferred. Hereinafter, in the channel region 51, the length in the carrier transfer direction, namely the distance between the source electrode 3 and the drain electrode 4 is referred to as a channel length L, and the length in the direction perpendicular to the channel length L direction is referred to as a channel width W.

The thin film transistor 1 described above is a transistor with a configuration in which the source electrode 3 and the drain electrode 4 are provided via the gate-insulating layer 6 nearer to the substrate 2 than the gate electrode 7, namely a thin film transistor with the top-gate structure.

Hereinafter, each part of the thin film transistor will be sequentially described.

The substrate 2 is a member for supporting each of the layers (each of the sections) composing the thin film transistor 1. Preferred examples for the substrate 2 include a plastic substrate (a resin substrate) made of polyimide, polyethylene terephthalate (PET), polyethylene naphthalate (PEN), polyethersulfone (PES), aromatic polyester (liquid crystal polymer), a glass substrate, a quartz substrate, a silicon substrate, and a gallium arsenide substrate. If the thin film transistor needs to be flexible, a resin substrate is selected.

A foundation layer can be provided on the substrate 2. This foundation layer, for example, prevents ions from diffusing from the surface of the substrate 2, or enhances adhesiveness (joining property) of the source electrode 3 and the drain electrode with the substrate 2.

The material for the foundation layer is not limited, but if the substrate 2 is a glass substrate, silicon dioxide (SiO₂) or silicon nitride (SiN) can preferably be used as the material for the foundation layer.

The source electrode 3 and drain electrode 4 are provided on the substrate 2 in the channel length L direction side by side with a predetermined distance. As materials for forming the source electrode 3 and the drain electrode 4, material that can be deposited by an electroless plating process can be used. Preferably, the materials composing each of the source electrode 3 and the drain electrode 4, include Ni, Cu, Co, Au, Pd, or materials composed mainly of alloys including these metals. By forming the source electrode 3 and the drain electrode 4 with these metal materials, the performance of the thin film transistors 1 can further be enhanced.

The average thicknesses of the source electrode 3 and the drain electrode 4 is not limited, but is preferably about 30-300 nm, further preferably about 50-150 nm. Such a thin electrode can precisely be formed with the method of the present invention.

The distance (edge-to-edge distance) between the source electrode 3 and the drain electrode 4, namely the channel length L is preferably about 2-30 µm, further preferably about 5-20µm. If the channel length L is below 2 µm there may be a margin of error in the channel lengths of the obtained thin film transistors 1, which in some cases may cause fluctuations in the transistor characteristics. In contrast, if the channel length L is greater than 30 µm, the absolute value of the threshold voltage becomes large while the amount of the drain current becomes small, which in some cases may cause an insufficient performance of the thin film transistor.

The channel width W is preferably about 0.1-5 mm, more preferably about 0.5-3 mm. If W is narrower than 0.1 mm the value of the drain current becomes smaller, which occasionally may cause an insufficient performance of the thin film transistor. In contrast, if W is wider than 5 mm the size of the thin film transistor becomes large, and an increased parasitic capacitance or increased leak current to the gate electrode 7 via the gate-insulating layer 6 may be result.

Further, on the substrate 2, there is provided the organic semiconductor layer 5 so as to cover the source electrode 3 and the drain electrode 4.

The organic semiconductor layer 5 is made mainly of an organic semiconductor material (an organic material presenting with an electrically conductive property similar to a semiconductor material), and is preferably arranged substantially parallel to the channel length L direction at least in a channel region 51. According to this structure, the carrier mobility in the channel region 51 is increased resulting in the faster operational speed of the thin film transistor 1.

Examples of suitable organic semiconductor materials include small molecule organic semiconductor materials such as naphthalene, anthracene, tetracene, pentacene, hexacene, phthalocyanine, perylene, hydrazone, triphenylmethane, diphenylmethane, stilbene, arylvinyl, pyrazoline, triphenylamine, triarylamine, oligothiophene, phthalocyanine, or derivatives of these, or polymeric semiconductor materials such as poly-N-vinylcarbazole, polyvinylpyrene, polyvinylanthracene, polythiophene, polyhexylthiophene, poly(p-phenylenevinylene), polythenylenevinylene, polyarylamine, pyrene-formaldehyde resin, ehtylcarbazole-formaldehyde resin, fluorene-bithiophene copolymer, fluorene-arylamine copolymer, or derivatives of these. These materials can be used alone or in combination, and particularly preferred are materials made mainly of polymeric organic semiconductor materials (conjugated polymeric materials), which have particularly high carrier migratory aptitude because of characteristic distributions of the electron clouds. For the reasons of oxidation resistance and stability in the air materials mainly made of at least one of fluorene-bithiophen copolymer, polyarylamine, or derivatives thereof are even more preferred as polymeric organic semiconductor materials (conjugated polymeric materials).

The polymeric organic semiconductor materials can be formed as films by simple processes, and are easily arranged in predetermined directions.

Further, the organic semiconductor layer 5 composed mainly of a polymeric organic semiconductor material, which can be used for forming thinner and/or light-weight products as well as excels in flexibility, is suitable for an application to thin film transistors used as switching elements for flexible displays.

The average thickness of the organic semiconductor layer 5 preferably is about 0.1-1000 nm, more preferably about 1-500 nm, further preferably about 10-100 nm.

It may be noted that the organic semiconductor layer 5 is not limited to those configured so as to cover the source electrode 3 and the drain electrode 4, but can be formed on at least an area (the channel region 51) defined between the source electrode 3 and the drain electrode 4.

The gate-insulating layer 6 is provided on the organic semiconductor layer 5, and serves to insulate the gate electrode 7 from the source electrode 3 and the drain electrode 4.

The gate-insulating layer 6 preferably is mainly composed of an organic material, particularly of an organic polymeric material, which can easy be formed and is capable to enhance adhesiveness with the organic semiconductor layer 5.

Examples of suitable organic polymeric materials include acrylic resins such as polystyrene, polyimide, polyamideimide, polyvinylphenylene, polycarbonate (PC) or polymethylmethacrylate (PMMA), fluorinated resins such as polytetrafluoroethylene (PTFE), phenolic resins such as polyvinylphenol or novolak resins, olefinic resins such as polyethylene, polypropylene, polyisobutylene, or polybutene, and these materials can be used alone or in combination with each other.

The average thickness of the gate electrode 6 is not particularly limited, but is preferably about 10-5000 nm, more preferably 100-1000 nm. With the thickness of the gate electrode 6 being in this range, the thin film transistor 1 can be kept small (in particular as regards the thickness thereof) while the source electrode 3 and the drain electrode 4 surly insulating from the gate electrode 7.

The gate-insulating layer 6 is not limited to a single layer structure, but can be of a stacked layer structure including a plurality of layers.

Further, inorganic insulating materials such as SiO₂ can be used as the material forming the gate-insulating layer 6. A layer of SiO₂ can be obtained by coating a solution of e.g. polysilicate, polysiloxane or polysilazane and then heating the coated film in the presence of oxygen or water vapor. Also, an inorganic insulating material can be obtained by coating a metal alkoxide solution and heating in the presence of oxygen (known as a sol-gel process).

The gate electrode 7 is provided on the gate-insulating layer 6.

Examples of materials for forming the gate electrode 7 include metals such as Pd, Pt, Au, W, Ta, Mo, Al, Cr, Ti, Cu, or alloys including the above, electrically conductive oxides such as ITO, FTO, ATO and SnO₂, carbon materials such as carbon black, carbon nanotube and fullerene, electrically conductive polymers such as polyacetylene and polypyrrole, polythiophene such as PEDOT (poly-ethylenedioxythiophene), polyaniline, poly(p-phenylene), poly(p-phenylenevinylene), polyfluorene, polycarbazole, polysilane, or derivatives of the above, and usually used in a condition provided with conductivity by being doped with iron chloride, iodine, strong acid, organic acid, or polymer such as polystyrene sulfonic acid. Further, the above materials can be used alone or in combination.

The average thickness of the gate electrode 7 is not particularly limited, but is preferably about 0.1-5000 nm, more preferably about 1-5000 nm, further preferably about 10-5000 nm.

In the above thin film transistors 1, the amount of current flowing between the source electrode 3 and the drain electrode 4 can be controlled by altering the voltage applied to the gate electrode 7. Namely, in an OFF state with no voltage applied to the gate electrode 7, even if some voltage is applied between the source electrode 3 and the drain electrode 4, only very little current flows because very little carriers exist in the organic semiconductor layer 5. In contrast, in an ON state with substantial voltage applied to the gate electrode 7, electrical charge is induced in a portion of the organic semiconductor layer 5 facing the gate electrode 6 to form a flow channel for the carrier in the channel region 51. In this condition, if substantial voltage is applied between the source electrode 3 and the drain electrode 4, current flows through the channel region 51.

The thin film transistor 1 described above can be manufactured according the method described below, exemplifying a first and a second manufacturing method.

### First Manufacturing Method

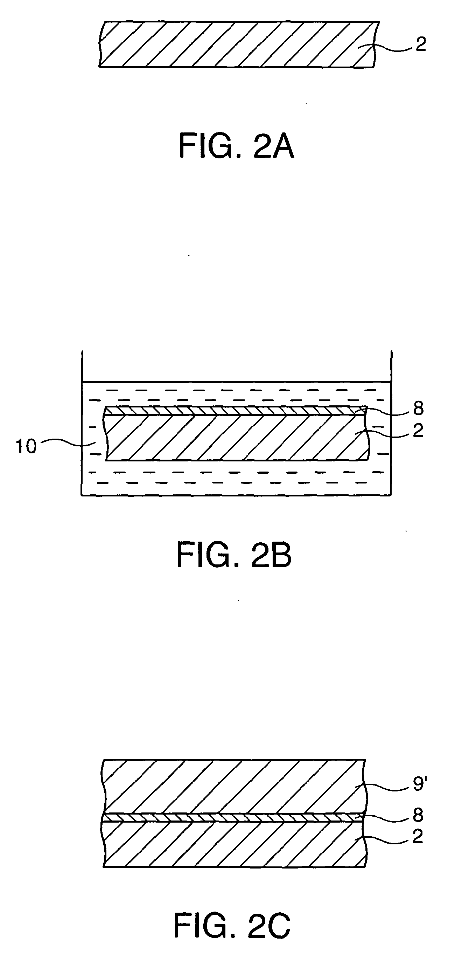

A first manufacturing method for manufacturing a thin film transistor according to the present invention is exemplified by FIGS. 2A-4J illustrating a method for the manufacture of the thin film transistor shown in FIGS. 1A and 1B. The upper side of FIGS. 2A-4J is referred to as "upper side" and the lower side thereof is referred to as "lower side" in the following description.

The present first manufacturing method comprises the step of:
[A1] forming the source electrode and the drain electrode,
[A2] removing organic matter,
[A3] forming the organic semiconductor layer,
[A4] forming the gate-insulating layer, and
[A5] forming the gate electrode

### First Step [A1]: Forming the Source and Drain Electrodes

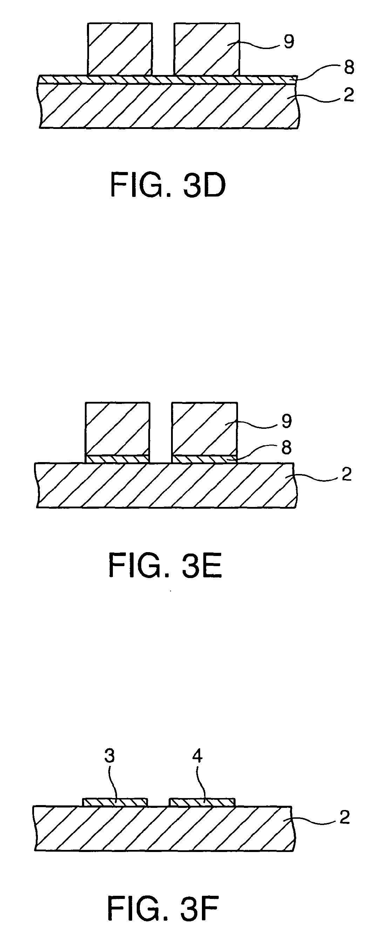

[A1-I] Firstly, the substrate 2 as shown in FIG. 2A is provided and then washed, e.g. with (purified) water and/or organic solvent, either alone or in combination. This procedure improves the wettability of the substrate 2 to water, thus facilitating the contact with various processing fluids shown below.
   If a resin substrate made of, for example, polyimide is used as the substrate 2, a process for enhancing the adhesiveness of a surface of the substrate 2 with the source electrode 3 and the drain electrode 4 is preferably conducted on that surface prior to the present step [A1-I] (the step [A1]). This process (surface roughening) is conducted by etching the surface of the substrate 2 with an etching fluid and then treating with a processing fluid including a reducing agent.
   Examples of the etching fluid include fluids including a transition metal oxide, such as CrO₃, or MnO₂, and inorganic acids such as sulfuric acid or hydrochloric acid.
   The reducing agent used for the processing fluid is not particularly limited, but is preferably selected from those substantially free of alkali metals. In this case no alkali metal ions are captured on the surface of the substrate 2 and alkali metal ions are prevented from diffusing to (interfusing in) the organic semiconductor layer 5 formed in a later step. As a result, a deterioration of the performance of the organic semiconductor layer 5 can be prevented.
   Examples of the reducing agent include ammonium compounds, such as ammonium sulfite hydrate or ammonium hypophosphite, or hydrazine. Due to their superior reduction performance those mainly composed of ammonium compounds are preferred, and more preferred are those composed mainly of ammonium sulfite hydrate.
[A1-II] Subsequently, pre-processing for forming a plated film 8 is conducted, e.g. by contacting a solution including a cationic surface-active agent or an anionic surface-active agent with the substrate 2. By this treatment the surface-active agent is attached on the surface of the substrate 2.
   The surface of the substrate 2 is positively charged when the cationic surface-active agent is attached, or is negatively charged when the anionic surface-active agent is attached. If the charge polarity of a catalytic agent used in the electroless plating is opposite to the charge of the substrate, the catalytic agent is easy to be attached thereto, and consequently, the adhesiveness of the substrate 2 with the plated film 8 (the source electrode 3 and the drain electrode 4) to be formed is enhanced.
   Although various methods are suitable for contacting the surface-active solution with the substrate 2, specific examples include a method of dipping the substrate 2 into the surface-active solution and a method of spraying the surface-active solution onto the substrate 2. The dipping method is particularly preferable because a large amount of substrate 2 can easily be processed by the dipping method. An example of a dipping method is illustrated below.
   Examples of the cationic surface-active agent include alkyl ammonium chloride, benzalkonium chloride, benzethonium chloride, and stearic acid, and they can be used alone or in combination.
   The temperature of the surface-active solution at use is preferably about 0-70°C, more preferably about 10-40°C. The time of dipping the substrate 2 into the surface-active solution is preferably about 10-90 sec, more preferably about 30-60 sec.
   The substrate 2 thus pre-processed is washed with e.g. purified water (ultra pure water), ion exchanged water, distilled water, or RO water.
[A1-III] Subsequently, the catalytic agent is attached on the surface of the substrate 2.
   As examples of the catalytic agent, Au, Ag, Pd and Pt can be cited, and these agents can be used alone or in combinations of one or more of them.
   If Pd is used as the catalytic agent, the substrate 2 is dipped in colloidal suspension of a Pd alloy such as Sn-Pd or a solution of an ionic Pd catalytic agent such as palladium chloride to attach the Pd alloy or the ionic Pd catalytic agent on the surface of the substrate 2. After that Pd is exposed on the substrate 2 by removing elements, which are not involved in the catalytic action.
   If a Sn-Pd colloidal suspension is used, the substrate 2, after being dipped in the colloidal suspension, may be dipped in an acidic solution to dissolve the Sn coordinated with Pd, so that Pd is exposed on the surface of the substrate 2.
   Examples of the acidic solution include a solution including an acid such as HBF₄ and a reducing agent such as glucose, or a solution made by adding sulfuric acid to the aforementioned solution.
   The temperature of the solution including the catalytic agent at use is preferably about 0-70°C, more preferably about 10-40°C. The time of processing the substrate 2 in the solution including the catalytic agent is preferably about 10 sec to 5 min, more preferably about 20 sec to 3 min.
   The same temperatures and processing times also apply for the processing with the acidic solution.
   The substrate 2, to which the catalytic agent is thus attached (absorbed), is washed with e.g. purified water (ultra pure water), ion exchanged water, distilled water, or RO water.
[A1-IV] Subsequently, as shown in FIG. 2B, the substrate 2 is dipped in the plating solution 10, and the metal element (simple metal element) is precipitated on the surface of the substrate 2 to form the plated film 8.
   As the plating solution 10 for electroless plating, those including a metal salt of the metal for forming the plated film 8 (the source electrode 3 and the drain electrode 4) and the reducing agent, but not substantially including any alkali metal ions are preferably used. Hence, when preparing the plating solution 10 by dissolving at least a metal salt and a reducing agent in a solvent, materials not including alkali metals are preferably used.
   Using such a plating solution 10 results in a plated film 8 not containing alkali metal ions, and as a result diffusion (mixing) of alkali metal ions into the organic semiconductor layer 5 to be formed in a later step, and thus the deterioration of the semiconductor layer 5 can be prevented.
   Preferred examples of the metal salt include sulfates and nitrates.
   Examples of the reducing agent include hydrazine and ammonium hypophosphite, and more preferred are those mainly composed of at least one of hydrazine and ammonium hypophosphite. By using these materials as the reducing agent under appropriate conditions (plating solution temperature and pH), the speed of forming the plated film 8 is made proper, which makes it easy to control the thickness of the film within the optimum range of the film thickness required to the source electrode 3 and the drain electrode 4.
   Also, the resulting plated film 8 can have an even thickness and preferable surface properties (high film surface morphology).
   The amount of the metal salt included in the plating solution 10 is preferably about 1-50 g/L, more preferably about 5-25 g/L. If the content of the metal salt is too small, it may take a long time to form the plated film 8. In contrast, if the content of the metal salt is increased beyond 50 g/L, the effectiveness may not be further increased.
   Further, the amount of the reducing agent included in the plating solution 10 is preferably about 10-200 g/L, more preferably about 50-150 g/L. If the amount of the reducing agent is too small, it may be difficult to efficiently reduce the metal ions depending on the nature of the reducing agent. In contrast, if the content of the reducing agent is increased beyond 200 g/L, the effectiveness may not be further increased.
   It is preferable that a pH adjuster (a pH buffer) is further added to the plating solution 10 to prevent or control that the pH of the plating solution 10 is lowered as electroless plating proceeds, and as a result a slow-down of the deposition rate or changes in composition or characteristics of the plated film 8 can effectively be avoided.
   Various pH adjusters can be used. Preferred are those mainly composed of at least one of ammonia water, trimethyl ammonium hydride and ammonium sulfide. Since these materials excel in buffering behavior, the aforementioned effect is remarkably exerted if these materials are used as pH adjustor.
   By dipping the substrate 2 having the catalytic agent attached thereto into the above plating solution 10, the electroless plating reaction is promoted with the nucleate catalytic agent, thus forming the plated film 8.
   The pH of the plating solution 10 at use is preferably about 5-12, more preferably about 6-10. The temperature of the plating solution 10 at use is preferably about 30-90°C, more preferably about 40-80°C. Also, the process time of the substrate 2 in the plating solution 10 is preferably about 10 sec to 5 min, more preferably about 20 sec to 3 min.
   If the pH and the temperature of and the processing time with the plating solution 10 are within the above ranges, the deposition rate becomes especially proper, and accordingly the plated film 8 having an even thickness can be formed with high precision.
   The thickness of the plated film 8 to be formed can be controlled by adjusting the plating conditions, such as the operation temperature (temperature of the plating solution), the operation time (the plating time), the amount of the plating solution, the pH of the plating solution, or the number of plating processes (the number of turns).
   Further, some additives such as a complexing agent, or a stabilizing agent can be added, if desired or necessary.
   Examples of the complexing agent include carboxylic acids such as ethylenediamine tetraacetic acid or acetic acid, oxycarboxylic acids such as tartaric acid or citric acid, aminocarboxylic acids such as glycine, amines such as triethanolamine, and polyhydric alcohols such as glycerin or sorbitol.
   Examples of stabilizing agents include 2,2'-bipyridyl, cyanide, ferrocyanide, phenanthroline, thiourea, mercaptobenzothiazole and thioglycolic acid.
   The substrate 2 on which the plated film 8 is thus formed is washed with e.g. purified water (ultra pure water), ion exchanged water, distilled water, or RO water.
[A1-V] Subsequently, the resist layer 9 having a shape corresponding to the source electrode 3 and the drain electrode 4 is formed on the plated film 8.
   Firstly, as shown in FIG. 2C, resist material 9' is deposited (provided) on the plated film 8. Then, it is exposed via a photo mask corresponding to the shapes of the source electrode 3 and the drain electrode 4, and then developed with a developing fluid. In this manner, as shown in FIG. 3D, the resist layer 9 patterned to have the shape corresponding to the source electrode 3 and the drain electrode 4 can be obtained.
[A1-VI] Then, using the resist layer 9 as a mask, as shown in FIG. 3E, unnecessary portion of the plated film 8 is removed by etching.
   In this etching process, one or more of processes including physical etching methods such as plasma etching, reactive etching, beam etching, or photo-assist etching, and chemical etching methods such as wet etching can be conducted alone or in combination. Among these processes wet etching is preferred, as this process can be conducted with simple steps and simple equipment (e.g. without requiring large-scale equipment such as a vacuum system).
   Examples of etching fluids used for the wet etching include solutions including iron chloride, and solutions including sulfuric acid, nitric acid or acetic acid.
[A1-VII] Afterwards, by removing the resist layer 9, the source electrode 3 and the drain electrode 4 as shown in FIG. 3F can be obtained.
   Although the resist layer 9 preferably is removed by using a resist removing fluid, other methods such as the physical etching methods mentioned above can also be applied.
   As described above, by using the photolithography method and the etching method in combination, the source electrode 3 and the drain electrode 4 with high dimensional accuracy can easily and surely be formed. Therefore, the distance (the channel length L) between the source electrode 3 and the drain electrode 4 can be set to be comparatively short, thus providing a thin film transistor 1 with low absolute threshold voltage value and large drain current, thus showing excellent characteristics necessary for switching elements.
   As the resist material of the photolithography method either a negative-type or a positive-type resist material can be used.

### Optional Step [A2]: Removing Organic Matters

Subsequently, the substrate 2 having the source electrode 3 and the drain electrode 4 formed thereon is washed with e.g. water (e.g. purified water) and/or organic solvents, either alone or in combination with each other.

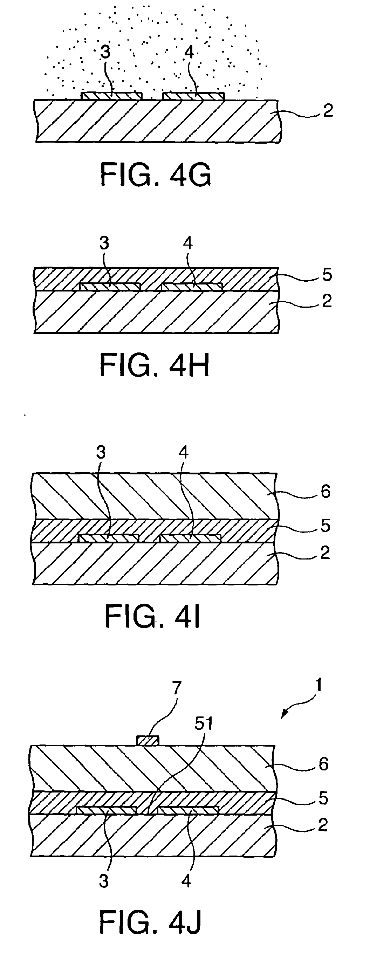

Then, as shown in FIG. 4G, any organic matters are removed from the surface of the substrate 2, on which the organic semiconductor layer 5 is to be formed. Thus, the barrier for the carrier in the interface between the organic semiconductor layer 5 and the source electrode 3, the drain electrode 4 can be removed to improve the characteristics of the thin film transistor 1.

Examples of methods of removing organic matters include a plasma process, a process with ozone water, etching with an acid or an alkali, mechanical removal of the surface layer, and UV-irradiation (particularly deep UV), and they can be applied alone or in combination with each other. Among them, the plasma process is preferred, since the organic matters can surely be removed in a short period of time.

When conducting the plasma process, the substrate 2 is placed in a chamber equipped with a decompression means and a plasma generation means, and can be processed by generating plasma in the chamber in a decompressed condition, or by ejecting plasma against the surface of the substrate from a head equipped with a plasma ejection nozzle.

In the latter method the chamber and the decompression means can be omitted, since the plasma process can be conducted under atmospheric pressure, thus providing the advantages of low manufacturing costs and a short cycle times in manufacturing.

The conditions of the atmospheric pressure plasma include for example a gas flow rate of about 10-300 sccm, and an RF power of about 0.005-0.2 W/cm².

The gas used for plasma generation is not particularly limited, but preferred are gases mainly composed of at least one of oxygen, nitrogen, argon, helium, and fluorocarbon. Since plasma can be generated in low vacuum atmosphere or under atmospheric pressure by mixing argon or helium with the main component, the equipment can be simplified.

It may be noted that the present step [A2] can be omitted if needed or desired.

### Second Step [A3]: Forming an Organic Semiconductor Layer

As shown in FIG. 4H, the organic semiconductor layer 5 is formed on the substrate 2 having the source electrode 3 and the drain electrode 4 formed thereon using a coating method so as to cover the source electrode 3 and drain electrode 4.

Thereby, the channel region 51 is formed between the source electrode 3 and the drain electrode 4 (an area corresponding to the gate electrode 7).

Specifically, the organic semiconductor layer 5 can be formed by coating a solution comprising an organic polymeric material or a precursor thereof on the substrate 2, so as to cover the source electrode 3 and the drain electrode 4, and then subjecting the coated film to a post-processing step (e.g., heating, IR-irradiation or irradiation with ultrasonic waves) as needed.

Examples of coating methods include spin-coating, casting, micro gravure coating, gravure coating, bar coating, roller coating, wire bar coating, dip coating, spray coating, screen printing, flexographic printing, offset printing, ink-jet printing and micro-contact printing, and these methods can be used alone or in combination with each other.

The area in which the organic semiconductor layer 5 is formed is not limited to the structure shown in the drawings, and the organic semiconductor layer 5 can be formed only in the area (the channel region 51) defined between the source electrode 3 and the drain electrode 4.

According to this structure, if a plurality of thin film transistors 1 (elements) is arranged on a single substrate, the organic semiconductor layer 5 for each element can separately be formed to reduce leak current and crosstalk between each of the elements. Further, the necessary amount of the organic semiconductor material can be reduced, thus reducing the manufacturing costs. If the organic semiconductor 5 is formed only in the channel region 51, the ink-jet method, which can be conducted in a contact-free manner, is particularly suitable. Further, the required resolution of 5-100 µm matches the resolution of the ink-jet method.

In this case, examples of the solvent for dissolving the organic semiconductor material include inorganic solvents such as nitric acid, sulfuric acid, ammonia, hydrogen peroxide, water, carbon disulfide, carbon tetrachloride, or ethylene carbonate, various organic solvents including ketones such as methyl ethyl ketone (MEK), acetone, diethyl ketone, methyl isopropyl ketone (MIPK), or cyclohexanon, alcohols such as methanol, ethanol, isopropanol, ethylene glycol, diethylene glycol (DEG), or glycerine, ethers such as diethyl ether, diisopropyl ether, 1,2-dimetoxy ethane (DME), 1,4-dioxane, tetrahydrofuran (THF), tetrahydropyran (THP), anisole, diethylene glycol dimethyl ether (diglyme), or diethylene glycol ethyl ether (carbitol), cellosolve™ solvents such as methyl cellosolve, ethyl cellosolve, or phenyl cellosolve, aliphatic hydrocarbons such as hexane, pentane, heptane or cyclohexane, aromatic hydrocarbons such as toluene, xylene or benzene, heteroaromatic solvents such as pyridine, pyrazine, furan, pyrrole, thiophene, or methylpyrrolidone, amides such as N, N-dimethylformamide (DMF) or N, N-dimethylacetamide (DMA), halogenated compounds such as dichloromethane, chloroform, or 1,2-dichloroethane, esters such as ethyl acetate, methyl acetate, or ethyl formate, sulfur compounds such as dimethyl sulfoxide (DMSO) or sulfolane, nitriles such as acetonitrile, propionitrile, or acrylonitrile, organic acids such as formic acid, acetic acid, trichloroacetic acid, or trifluoroacetic acid, or mixed solvents including the above.

Since the organic semiconductor includes a conjugated system such as an aromatic hydrocarbon group or a heterocyclic group, it is generally easily dissolved in aromatic hydrocarbon solvents.Particularly suitable solvents are toluene, xylene, trimethyl benzene, tetramethyl benzene or cyclohexyl benzene.

### Third Step [A4]: Forming a Gate-Insulating Layer

As shown in FIG. 4I, the gate-insulating layer 6 is formed on the organic semiconductor layer 5 using a coating method.

Specifically, the gate-insulating layer 6 can be formed by coating a solution including an insulating material or a precursor thereof on the organic semiconductor layer 5, and then subjecting the coated film to a post-processing step (e.g., heating, IR-irradiation or irradiation with ultrasonic waves) as needed.

Further, the coating method may be the same as above. If the organic semiconductor layer 5 is composed of a soluble organic semiconductor material, a solvent, which does not swell or dissolve the organic semiconductor layer 5, should be selected as the solvent for the insulating material. Since the organic semiconductor materials are easily dissolved in aromatic hydrocarbons as described above, such solvents should preferably be avoided when coating the insulating materials. Preferably, water-like solvents, alcohols solvents, ketones, ethers, esters solvents, aliphatic hydrocarbons solvents, or fluorinated solvents are used.

### Fourth Step [A5]: Forming a Gate Electrode

Subsequently, as shown in FIG. 4J, the gate electrode 7 is formed on the gate-insulating layer 7 using the coating method.

Specifically, the gate electrode 7 can be formed by coating a solution including an electrically conductive material (electrode material) or a precursor thereof on the gate-insulating layer 6, and then subjecting the coated film to a post-processing step (e.g., heating, IR-irradiation or irradiation with ultrasonic waves) as needed.

Further, although the same method as described above can be used as the coating method, the ink-jet method is particularly preferable, since a gate electrode 7 having a predetermined shape can easily and surely be formed. An example of forming the gate electrode 7 using the ink-jet method is described below.

In the ink-jet method patterning is conducted by ejecting droplets of a solution including an electrically conductive material or a precursor thereof (hereinafter referred to as "ink") from a nozzle of a droplet ejection head.

The viscosity of the ink (at room temperature) is not particularly limited, but is generally preferably about 3-10 cps, more preferably about 4-8 cps. If the viscosity is in the above range the droplets can be ejected from the nozzle more stably.

Further, the average ink droplet volume is not particularly limited, but is general preferably about 0.1-40 pL, more preferably about 1-30 pL. If the average volume of a single droplet is in the range mentioned above, more precise shapes can be formed.

Examples of the materials useful ink include those described in <A> through <D> below.
<A> If the gate electrode 7 is composed of an organic polymeric material, a solution dissolving the organic polymeric material is used as the ink.
   In this case, examples of the solvent include inorganic solvent such as nitric acid, sulfuric acid, ammonia, hydrogen peroxide, water, carbon disulfide, carbon tetrachloride, or ethylene carbonate, various organic solvents including ketones such as methyl ethyl ketone (MEK), acetone, diethyl ketone, methyl isopropyl ketone (MIPK), or cyclohexanon, alcohols such as methanol, ethanol, isopropanol, ethylene glycol, diethylene glycol (DEG) or glycerine, ethers such as diethyl ether, diisopropyl ether, 1,2-dimetoxy ethane (DME), 1,4-dioxane, tetrahydrofuran (THF), tetrahydropyran (THP), anisole, diethylene glycol dimethyl ether (diglyme) or diethylene glycol ethyl ether (carbitol), cellosolve™ solvents such as methyl cellosolve, ethyl cellosolve or phenyl cellosolve, aliphatic hydrocarbons such as hexane, pentane, heptane or cyclohexane, aromatic hydrocarbons such as toluene, xylene or benzene, heteroaromatic solvents such as pyridine, pyrazine, furan, pyrrole, thiophene or methylpyrrolidone, amides such as N,N-dimethylformamide (DMF) or N, N-dimethylacetamide (DMA), halogenated compounds such as dichloromethane, chloroform or 1,2-dichloroethane, esters such as ethyl acetate, methyl acetate or ethyl formate, sulfur compounds such as dimethyl sulfoxide (DMSO) or sulfolane, nitriles such as acetonitrile, propionitrile or acrylonitrile, organic acids such as formic acid, acetic acid, trichloroacetic acid or trifluoroacetic acid, or mixed solvent including the above.
<B> If the gate electrode 7 is composed of an inorganic material, dispersion liquids including particles of the inorganic material (metal particles) can be used as the ink.
   In particular, as particles of the inorganic material (metal particles) those mainly composed of Ag are preferred. By using such particles mainly composed of Ag, the ink can easily be prepared, and further, high conductivity can be obtained in the resulting gate electrode 7.
   In this case, the content of the particles of the inorganic material in the ink is not particularly limited, but is preferably about 1-40 wt.-%, more preferably about 10-30 wt.-%.
   Further, the average particle diameter of the inorganic material particles is not particularly limited, but is preferably about 1-100 nm, more preferably about 2-30 nm.
   Further, particles coated with a coagulation inhibition agent (a dispersing agent) for inhibiting coagulation at room temperature are preferably used for the inorganic material particles. Examples of the coagulation inhibition agent include compounds having a nitrogen-containing group such as alkylamine, compounds having an oxygen-containing group such as alkanediol, and compounds having a sulfur-containing group such as alkylthiol or alkanethiol.
   In this case, an agent for removing the coagulation inhibition agent by a predetermined process (e.g. heating) is added into the ink. Examples of the removing agent include various carbonic acids, including straight or branched saturated C₁₋₁₀-carbonic acids such as formic acid, acetic acid, proponic acid, butanoic acid, hexanoic acid or octylic acid, unsaturated carbonic acids such as acrylic acid, methacrylic acid, crotonic acid, cinnamic acid, benzoic acid or sorbic acid, dibasic acids such as oxalic acid, malonic acid, sebacic acid, maleic acid, fumaric acid or itaconic acid, organic acids including various phosphoric acids and various sulfonic acids substituting the carboxyl groups of the above carbonic acids with phosphate groups or sulfonyl groups, esters derived from the above organic acids, aromatic acid anhydrides such as phthalic anhydride, trimellitic anhydride, pyromellitic dianhydride, benzophenone tetracarboxylic dianhydride, ethylene glycol bis(anhydrotrimellitate) or glycerol tris(anhydrotrimelitate), cyclic acid anhydrides such as maleic anhydride, succinic anhydride, tetrahydrophthalic anhydride, methyltetrahydrophthalic anhydride, methyl phthalic anhydride, alkenyl succinic anhydride, hexahydro phthalic anhydride, methylhexahydro phthalic anhydride or methylsyclohexene tetracarboxylic dianhydride, fatty acid anhydrides such as polyadipic anhydride, polyazelaic anhydride or polysebacic anhydride.
   Examples of the dispersion medium to be used in clude terpineol, mineral spirit, xylene, toluene, ethyl benzene, mesitylene, hexane, heptane, octane, decane, dodecane, cyclohexane, cyclooctane, ethanol, isopropanol (IPA), water, or mixed fluids including the above.
   Further, precursors of various thermoset resins such as phenol resins, epoxy resins, unsaturated polyester resins, vinylester resins, diallyl phthalate resins, oligoester acrylate resins, xylene resins, bismaleimide triazine resins, furan resins, urea resins, polyurethane resins, melamine resins or silicone resins can be added into (mixed with) the ink.
   The viscosity of the ink can be controlled by e.g. adjusting the content of the inorganic material particles, the nature or the composition of the dispersion medium, or presence or absence or the nature of the additives.
<C> If forming the gate electrode 7 with a metal material, dispersion liquid including a reducing agent and metal oxide particles composed of metal oxide that becomes a metal material by being reduced can be used as the ink.
   In this case, the content of the particles of the metal oxide in the ink is not particularly limited, but is preferably about 1-40 wt.-%, more preferably about 10-30 wt.-%.
   Further, the average particle diameter of the metal oxide particles is not particularly limited, but is preferably no greater than 100 nm, more preferably no greater than 30 nm.
   Examples of the reducing agent include ascorbic acid, hydrogen sulfide, oxalic acid, and carbon monoxide.
   Examples of the dispersion medium include low viscosity oils such as butyl cellosolve or polyethylene glycol, alcohols such as 2-propanol, or mixed fluids including the above.
   The viscosity of the ink can be controlled by e.g. adjusting the content of the metal oxide particles, the nature or the composition of the dispersion medium.
<D> If the gate electrode 7 is composed of metal oxide, solution including the precursor of the metal oxide can be used as the ink.

Examples of the precursor of the metal oxide to be used include organic metal compounds such as metal alkoxides or metal salts of acetic acid or acetic acid derivatives, and inorganic metal compounds such as metal chlorides, metal sulfides, or metal cyanides, and these precursors can be used alone or in combination with each other.

The concentration of the metal oxide precursor in the ink is not particularly limited, but is preferably about 1-50 wt.-%, more preferably about 10-30 wt.-%.

Further, examples of the solvent include water, polyhydric alcohols such as ethylene glycol, glycerine, diethylene glycol, or triethanolamine, or monoalcohols such as methanol, ethanol, isopropanol, butanol, allyl alcohol, furfuryl alcohol, ethylene glycol monoacetate, or mixed fluids including the above.

The viscosity of the ink can be controlled by e.g. adjusting the concentration of the precursor of the metal oxide, the nature or the composition of the solvent.

After going through the steps described above, the thin film transistor shown in FIGS. 1A and 1B can be obtained.

In such a manufacturing method a large-scale equipment such as a vacuum equipment are not required, since the source electrode 3 and the drain electrode 4 are formed by electroless plating, while the organic semiconductor layer 5, the gate-insulating layer 6, and the gate electrode 7 are formed by a coating method. Thus the thin film transistor 1 can be manufactured by simple processes at low costs.

Further, by forming the source electrode 3 and the drain electrode 4 by electroless plating, these electrodes can be formed with high dimensional accuracy. Thus the thin film transistor 1 can be of superior characteristics (switching characteristics).

Even further, by using a plating solution 10 substantially free of any alkali metal ions in the electroless plating process, interfusion of the alkali metal ions to the source electrode 3 and the drain electrode 4 can be prevented, thus preventing a diffusion of alkali metal ions from into the organic semiconductor layer 5. Thus, the characteristics of the organic semiconductor layer 5 can be prevented from deteriorating, and as a result, a thin film transistor 1 having superior characteristics as a switching element can be manufactured.

Further, by removing organic matters in step [A2], the characteristics of the thin film transistor 1 are further enhanced.

Still further, by removing organic matters in step [A2] using an atmospheric pressure plasma method, and removing the plated film 8 in step [A1] by using a wet-etching process, it is possible to conduct all manufacturing steps under atmospheric pressure, thus reducing the manufacturing costs and time.

### Second Manufacturing Method

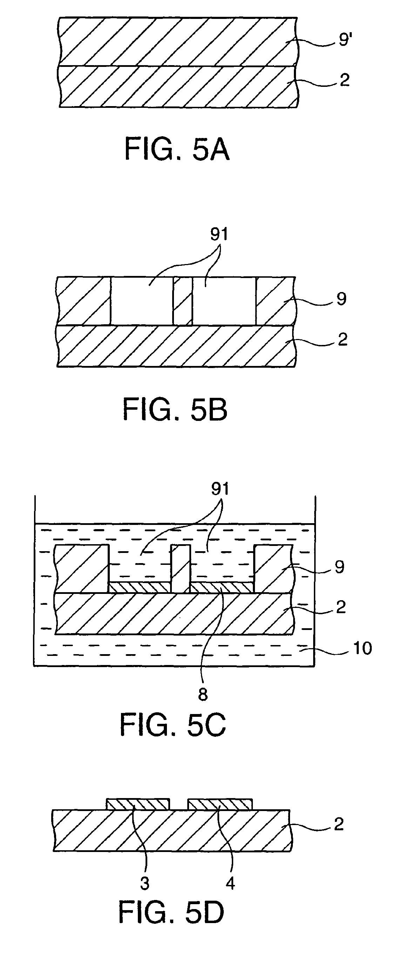

A second manufacturing method for manufacturing a thin film transistor according to the present invention is exemplified by FIGS. 5A-5D illustrating a method for the manufacture of the thin film transistor shown in FIGS. 1A and 1B. The upper side of FIGS. 5A-5D is referred to as "upper side" and the lower side thereof is referred to as "lower side" in the following description.

Hereinafter, the second manufacturing method is described with a focus mainly on the differences as compared with the first manufacturing method described above, and the descriptions regarding the common matters are omitted.

In the second method, the steps of forming the source electrode and the drain electrode are different from the first method, while the other steps are common.

**First Step [B1]:** Forming the Source and Drain Electrodes
[B1-I]: Firstly, the substrate 2 is washed as in step [A1-I].
   Then, a the substrate 2 is subjected to a pre-processing step (e.g. a process for enhancing the adhesiveness of the resist layer 9 with the substrate 2) for forming the plated film 8.
   Examples of the pre-processing include a primer treatment using silazanes such as hexamehtyldisilazane (HMDS), chlorosilanes such as dimethylchlorosilane or trimethylchlorosilane, alkoxysilanes such as dimethyldimethoxysilane or hexyltrimethoxysilane, or a titanate coupling agent.
[B1-II]: Subsequently, the resist layer (mask) 9 is formed in an area other than the area for forming the source electrode 3 and the drain electrode 4.
   Firstly, as shown in FIG. 5A, resist material 9' is deposited (provided) on the substrate 2. Then, it is exposed via a photo mask corresponding to the shapes of the source electrode 3 and the drain electrode 4, and then developed by developing fluid. Accordingly, as shown in FIG. 5B, the resist layer 9 patterned to have the shape corresponding to the area except for the area for forming the source electrode 3 and the drain electrode 4 can be obtained.
   A plating layer is not formed on the resist layer 9, and in order to selectively form the source electrode 3 and the drain electrode 4, the metal catalytic agent needs to be selectively absorbed to the substrate in the following step. To that end, the difference (contrast) in the charge conditions between the surface of a glass (or the substrate) and the resist layer 9 is preferably large. If the substrate is made of glass, it is generally charged negatively. The resist layer 9 is preferably charged positively. Examples of such a resist material include commercial materials such as "PMER series" produced by Tokyo Ohka Kogyo Co., Ltd. To further stabilize the positive charge a charge control agent is preferably further added to the resist material. Further, absorbing a surface-active agent can enhance the charge contrast.
[B1-III]: Subsequently,the substrate 2 is subjected to a pre-processing for forming a plated film 8.
   A plating layer is not formed on the resist layer 9, and before all surface is modified by cleaning the substrate as a pre-process of a method of selectively forming the plated film 8 on the substrate 2 in the area for forming the source electrode 3 and the drain electrode 4. To this end UV irradiation is conducted, e.g. by fully irradiating with the UV-light having a wavelength range 254-360 nm. Subsequently, the submerged surface potentials of the substrate and the resist layer, respectively, are controlled to generate a difference by using a specific surface-active agent on the substrate and the resist layer. For example, if the substrate is made of glass and "PMER series" produced by Tokyo Ohka Kogyo Co., Ltd mentioned in [B1-II] is used for the resist, an amine-anionic surface-active agent is used.
   Examples of the method of bringing the surface-active solution into contact with the substrate 2 include dipping the substrate 2 into the surface-active solution (a dipping method) and spraying the surface-active solution onto the substrate 2. The dipping method is particularly preferable. According to the dipping method, a large number of the substrates 2 can easily be processed.
   The temperature of the surface-active solution at use is preferably about 0-70°C, more preferably about 10-40°C. Further, the process time of the substrate 2 in the surface-active solution is preferably about 10-90 sec, more preferably about 30-60 sec.
   The substrate 2 thus pre-processed is washed using e.g. purified water (ultra pure water), ion exchanged water, distilled water, or RO water.
[B1-IV]: Then, a process is conducted, in which the metal catalytic agent is selectively absorbed to the area with no resist on the substrate 2, namely the area where the submerged surface potential of the substrate matches the metal catalytic agent.
   As examples of the catalytic agent, Au, Ag, Pd and Pt can be cited. If e.g. Pd is used as the catalytic agent, the Pd catalytic agent is absorbed onto the surface of the substrate 2 by dipping the substrate 2 in an ionic Pd catalytic agent such as palladium chloride.
   The temperature of the solution including the catalytic agent at use is preferably about 0-70°C, more preferably about 10-40°C. Further, the process time of the substrate 2 in the solution including the catalytic agent is preferably about 10 sec to 5 min, more preferably about 20 sec to 3 min.
   The substrate 2, to which the catalytic agent is thus attached (absorbed), is washed using e.g. purified water (ultra pure water), ion exchanged water, distilled water, or RO water.
[B1-V]: Subsequently, as shown in FIG. 5C, the metal element is deposited inside hollow sections (openings) 91 of the resist layer 9 to form the plating film 8.
   This process can be conducted similarly to step [A1-IV].
   The resist layer 9 is then removed. According to this process, as shown in FIG. 5D, the source electrode 3 and the drain electrode 4 are formed.
   According to the second manufacturing method, the same performance and advantages as in the first manufacturing method can be obtained.
   Further, in the second method the manufacturing processes can further be simplified, since the etching process of the plated film 8 can be omitted in the process of forming the source and drain electrodes.
   Further, in the second manufacturing method the consumption of the plating solution can also be reduced, since the source electrode 3 and the drain electrode 4 can selectively be formed.

### Second Configuration of the Thin Film Transistor

A second configuration (a second embodiment) of a thin film transistor of the present invention is hereinafter explained.

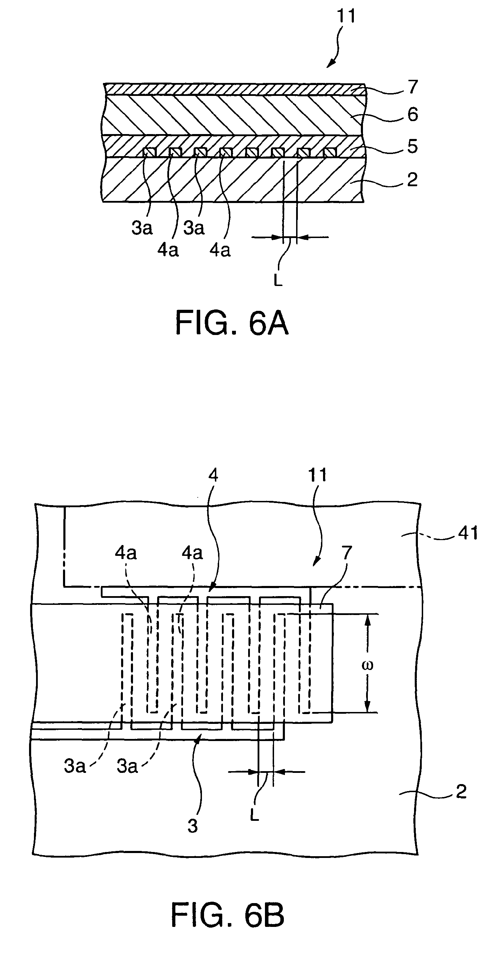

FIGS. 6A and 6B illustrate the thin film transistor of the second configuration, in which FIG. 6A is a vertical cross-sectional view, and FIG. 6B is a plan view. The upper side of FIG. 6A is referred to as "upper side" and the lower side thereof is referred to as "lower side" in the following descriptions.

The second configuration of the thin film transistor and the method of its manufacture are described with a focus mainly on the differences as compared with the first configuration and the first and second manufacturing methods described above, and the descriptions regarding the common matters are omitted.

The thin film transistor 11 of the second configuration differs from the first configuration as regards the shapes of the source electrode 3 and the drain electrode 4, and is the same in other aspects.

Namely, in the transistor 11 shown in FIGS. 6A and 6B, both of the source electrode 3 and the drain electrode 4 have a comb teeth-like shape and are formed such that the comb teeth of one electrode engages with those of the other. More specifically, the source electrode 3 and the drain electrode 4 respectively have electrode fingers 3a and 4a each aligned with a predetermined pitch and forming as a whole a comb-like shape. Further, the source electrode 3 and drain electrode 4 are provided such that the electrode fingers 3a and 4a are aligned alternately.

Further, the gate electrode 7 is provided on the gate-insulating layer 6 so as to overlap the area where the electrode fingers 3a and 4a are aligned alternately.

In the thin film transistor 11, a part of the organic semiconductor layer 5 positioned between each of the electrode fingers 3a of the source electrode 3 and each of the electrode fingers 4a of the drain electrode 4 is defined as a channel region through which carriers are transferred. Further, the length in the carrier transfer direction in the area between each of the electrode fingers 3a and each of the electrode fingers 4a (i.e. the distance between each of the electrode fingers 3a and 4a) corresponds to the channel length L, and the product of the length ω in the direction perpendicular to the channel length direction and the number N of the distances (gaps) between the electrode fingers 3a and 4a makes the channel width W.

The width A of each of electrode fingers 3a and 4a is preferably < 20 µm, more preferably ≤ 10 µm. Further, the channel length L is preferably < 20 µm, more preferably ≤ 10 µm. The channel width W can be the same as in the first configuration.

The thin film transistor 11 can be manufactured through similar steps as in the first manufacturing method, except that the resist layer 9 for patterning the plated film 8 is formed in accordance with a comb teeth-like pattern in step [A1]. Also, it can be manufactured through similar steps as in the second manufacturing method, except that the resist layer 9 for patterning the plated film 8 is formed in accordance with a comb teeth-like pattern in step [B1].

With the thin film transistor 11 of the second configuration, the same performance and advantages as the thin film transistor 1 of the first configuration can also be obtained.

Since in thin film transistors sections where the source electrodes or the drain electrodes overlap the gate electrodes generally function as capacitors, the capacitances of the gate electrodes increase as the areas of the overlapping sections increase, thus making it difficult to be driven faster. If the gate electrode is formed by a coating method the area of the overlapping section must have been large in conventional structures, since it is difficult to form a narrower pattern than 20 micron from the limit of the resolution.

In contrast, in the thin film transistor 11 in which the source electrode 3 and the drain electrode 4 are formed like the comb teeth and the areas between respective electrode fingers 3a and 4a are defined as the channel region, the area of the section where the gate electrode 7 overlaps the source electrode 3 or the drain electrode 4 is determined by the width A of the electrode fingers 3a and 4a. Furthermore, in the present invention the source electrode 3 and the drain electrode 4 are formed using a resist layer formed by lithography process as a mask. Therefore, the width A of the electrode fingers 3a and 4a depends on the resolution of the lithography process, and since the resolution of the lithography process is extremely high, the width A can be narrowed.

Accordingly, even if the gate electrode 7 is formed to have relatively large width, the area of the section where the gate electrode 7 overlaps the source electrode 3 or the drain electrode 4 can be prevented from increasing. Thus, in the thin film transistor 11, the gate capacitance can be held at a low value, and consequently good characteristics (switching characteristics) can be obtained.

As described above, since the gate electrode 7 is not required to be formed in a fine shape in the present embodiment, the process can be selected from wider alternatives, and even if various kinds of coating methods are used for forming the gate electrode 7, a thin film transistor 11 having good characteristics can be obtained.

### Electronic Device

An electronic device equipped with an active matrix device comprising thin film transistors 1, 11 as described above is now described using an electrophoretic display device as an example.

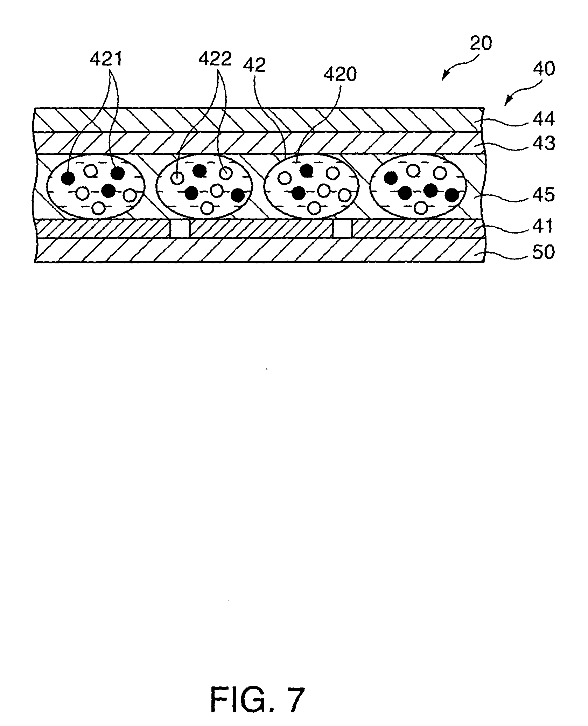

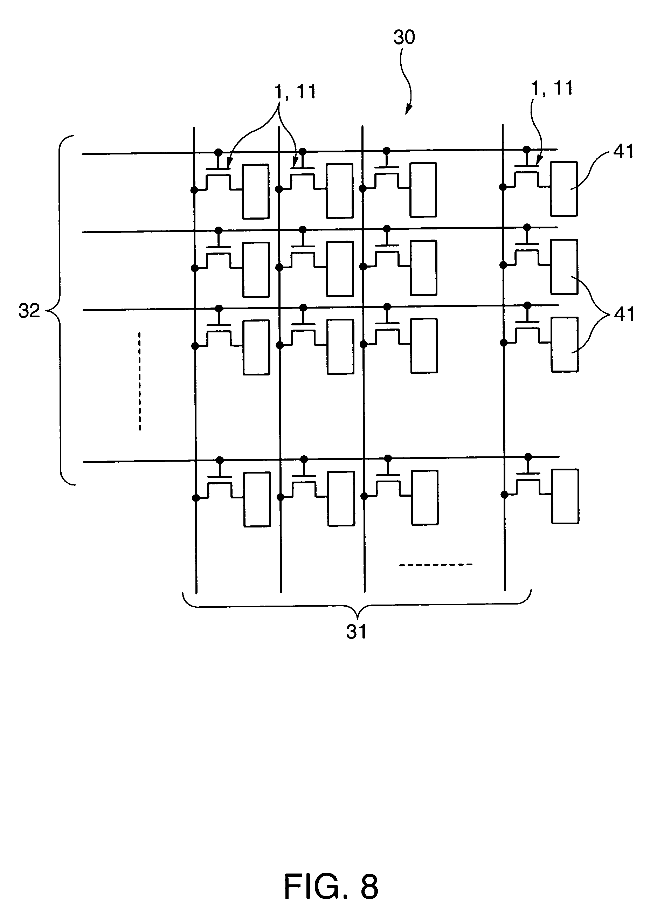

FIG. 7 is a vertical cross-sectional view showing an embodiment wherein an electronic device of the present invention is applied to an electrophoretic display device. FIG. 8 is a block diagram showing a configuration of an active matrix device installed in the electrophoretic display device shown in FIG. 7.

The electrophoretic display device 20 shown in FIG. 7 is composed of an active matrix device (a transistor circuit of the present invention) 30 provided on a substrate 50 and an electrophoretic display section 40 electrically connected to the active matrix device 30.

As shown in FIG. 8, the active matrix device 30 comprises a plurality of data lines 31, a plurality of scanning lines 32 perpendicular to the plurality of data lines, and the thin film transistors 1, 11 provided adjacent to each of the intersections of the data lines 31 and the scanning lines 32.

The gate electrodes 7, the source electrodes 3, and the drain electrodes 4 provided in the thin film transistors 1, 11 are respectively connected to the scanning lines 32, the data lines 31, and pixel electrodes (discrete electrodes) 41 described below.

As shown in FIG. 7, the electrophoretic display section 40 comprises the pixel electrode 41, a microcapsule 42, a transparent electrode (a common electrode) 43 and a transparent substrate 44 sequentially stacked on the substrate 50. The microcapsule 42 is fixed between the pixel electrode 41 and the transparent electrode 43 with a binder member 45. The pixel electrode 41 is divided into a matrix, namely so as to be aligned vertically and horizontally with regularity.

In each of the capsules 42, electrophoretic dispersion liquid 420 include plural kinds of electrophoretic particles having different characteristics from each other, two kinds of electrophoretic particles 421 and 422 having different charges and colors (hues) in the present embodiment.

If one or more of the scanning lines in the electrophoretic display device 20 described above are supplied with selection signals (selection voltages), the thin film transistors 1, 11 connected to the scanning lines supplied with the selection signals (selection voltages) are switched on.

Thus, the data lines 31 connected to this thin film transistor 1, 11 and the pixel electrodes 41 are substantially electrically connected. In this case, if the desired data (voltage) is supplied to the data line 31, the data (voltage) is then supplied to the pixel electrode 41.

Accordingly, an electric field is generated between the pixel electrode 41 and the transparent electrode 43, and the electrophoretic particles 421 and 422 are electrophoresed toward either of the electrodes in accordance with the direction and strength of the electric field, the characteristics of the electrophoretic particles 421 and 422, etc..

In this state, the thin film transistors 1, 11 are switched off bringing the data lines 31 and the pixel electrodes 41 connected to the thin film transistors 1, 11 into an electrically disconnected state, when the supply of the selection signal (selection voltage) to the scanning line 32 is stopped.

Therefore, by executing supplying or stopping the selection signals to the scanning lines 32, and supplying or stopping the data to the data lines 31 in combination, desired images (information) can be displayed on the display surface side (the transparent substrate 44 side) of the electrophoretic display device 20.

In particular, in the electrophoretic display device 20 of the present embodiment, the electrophoretic particles 421 and 422 are differently colored, thus enabling images with multiple depths to be displayed.

Further, since the present electrophoretic display device 20 is equipped with the active matrix device 30, the thin film transistor 1, 11 connected to a specific scanning line 32 can selectively be switched ON/OFF, thus the problem of cross-talk is difficult to arise, and further, the faster circuit operation is possible, which can obtain high quality images (information).

Even further, since the present electrophoretic display device 20 can operate with lower drive voltages, lower power consumption can be realized.

Note that the present electronic device is not limited to the application to an electrophoretic display device 20 as described above, but can also be applied to liquid crystal display devices, organic or inorganic EL display devices, etc..

### Electronic Apparatus

The electrophoretic display device 20 described above can be installed in various electronic apparatuses. The electronic apparatus of the present invention equipped with the electrophoretic display device 20 is hereinafter described.

### Electronic Paper

Firstly, an embodiment of applying the electronic apparatus of the present invention to the electronic paper is explained.

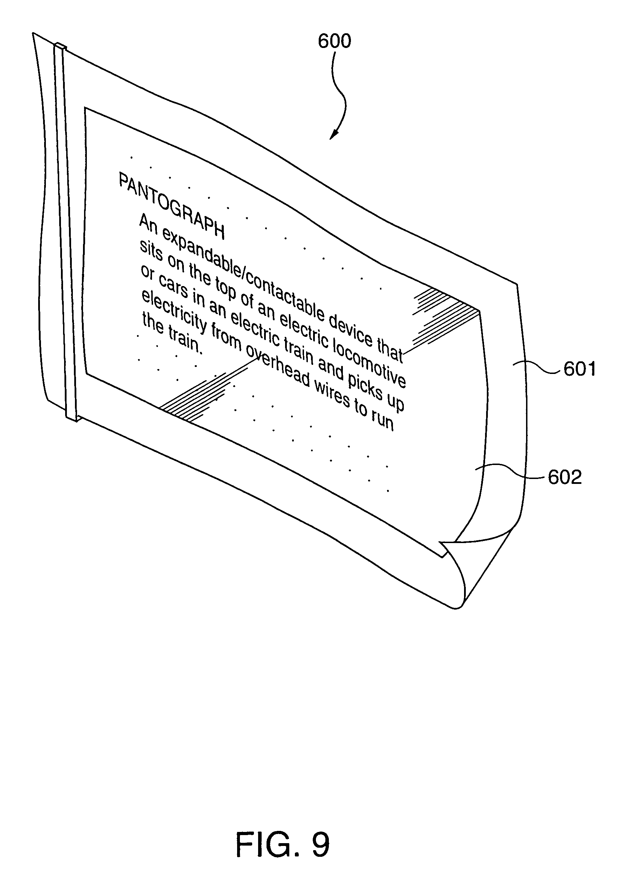

FIG. 9 is a perspective view showing the embodiment of applying the present electronic apparatus to an electronic paper.

The electronic paper 600 shown in this drawing is equipped with a main body 601 composed of a rewritable sheet, offering the same feeling of quality and having the same flexibility as paper, and a display unit 602. The display unit 602 is composed of the electrophoretic display device 20 as described above.

### Display

Then, an embodiment of applying the electronic apparatus of the present invention to a display is explained.

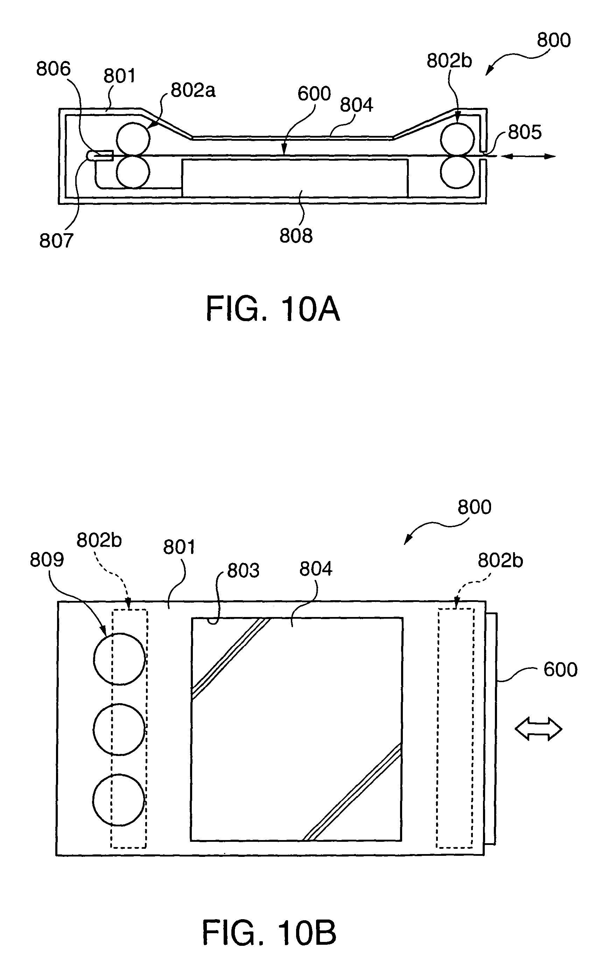

FIGS. 10A and 10B are views showing the embodiment of applying the present electronic apparatus to a display, where FIG. 10A is a cross-sectional view, and FIG. 10B is a plan view.

The display 800 shown in the drawing is equipped with a main body 801 and the electronic paper 600 detachably mounted on the main body 801. The configuration of the electronic paper 600 is as described above, namely the same as the configuration shown in FIG. 9.

The main body 801 is provided with an inlet 805 at a side thereof (right side of the figure) through which the electronic paper 600 can be inserted, and with two pairs of feed rollers 802a and 802b inside thereof. When the electronic paper 600 is inserted in the main body 801 through the inlet 805, the electronic paper 600 is positioned in the main body 801 while being held by the pairs of feed rollers 802a and 802b.

Further, in the display side (the near side of the paper in FIG. 10B) of the main body 801, there is formed a rectangular hollow section 803, in which a transparent glass plate 804 is engaged. Thus, the electronic paper 600 inserted and positioned in the main body 801 can be watched from outside the main body 801. Namely, in the display 800, the display surface is realized by making the electronic paper 600 positioned in the main body 801 be watched through the transparent glass plate 804.

Further, a terminal section 806 is provided on the tip portion of the electronic paper 600 in the inserting direction (left side in the figure), and a socket 807 is provided inside the main body 801, to which the terminal section 806 is connected when the electronic paper 600 is positioned in the main body 801. The socket 807 is electrically connected to a controller 808 and an operation section 809.

In the display 800, the electronic paper 600 can also be carried and used while being detached from the main body 801 since it is detachably mounted on the main body 801.

Further, in the display 800 described above, the electronic paper 600 is composed of the electrophoretic display device 20 described above.

The application of the electronic apparatus of the present invention is not limited to those described above, but includes, for example, a television, a video cassette recorder of either a view-fmder type or a direct view type, a car navigation system, a pager, a personal digital assistance, an electronic calculator, an electronic newspaper, a word processor, a personal computer, a workstation, a picture phone, a POS terminal, devices equipped with touch panels, and the electrophoretic display device 20 can be applied to display sections of the above various electronic apparatuses.

Although the method of manufacturing the thin film transistor, the thin film transistor, the thin film transistor circuit, the electronic device, and the electronic apparatus according to the present invention are described on the basis of specific embodiments, the present invention is not limited thereto. For example, although the thin film transistor is described using the top-gate structure type as an example in the embodiment, the present invention can also be applied to thin film transistors of the bottom-gate type. In this case, the gate electrode is formed using the electroless plating process.

Further, in the manufacturing method of the thin film transistor according to the present invention, one or more of steps of desired purposes can be added if necessary.

Also, then configuration of each section of the thin film transistor, the thin film transistor circuit, the electronic device, and the electronic apparatus can be replaced by or supplemented with a desired configuration functioning in a comparable manner.

### Examples

Specific examples according to the present invention are hereinafter described. In the following examples, purified water is used as water unless otherwise indicated.

### 1. Structure of Thin Film Transistor

### Example 1

Firstly, a glass substrate with a thickness of 1 mm is provided, and washed with water. Then, the glass substrate is dipped in an aqueous solution (25°C) of distearyl dimethyl ammonium chloride (cationic surface-active agent) for 60 sec. to absorb distearyl dimethyl ammonium chloride on the surface of the glass substrate, and the glass substrate is washed with water. Then, the glass substrate is dipped in a Sn-Pd colloidal suspension (25°C) for 60 sec. to absorb Sn-Pd on the surface of the glass substrate. Subsequently, the glass substrate is washed with water. After that, the glass substrate is dipped in an aqueous solution (25°C) including HBF₄ and glucose for 60 sec. to remove Sn from the surface of the glass substrate and to expose Pd on the surface of the glass substrate, and then the glass substrate is again washed with water.

Then, the glass substrate is dipped in a Ni plating solution (80°C, pH = 8.5) for 60 seconds to form a Ni plated film with a thickness of 100 nm on the surface of the glass substrate. The Ni plating solution is prepared by dissolving 10 g of nickel sulfate, 100 g of hydrazine (a reducing agent), 5 g of ammonium sulfide (a pH adjuster) with 1 L of water. Subsequently, a resist layer patterned correspondingly to the shapes of the source electrode and the drain electrode is formed on the Ni plated film by a lithography process, using "OPR800" produced by Tokyo Ohka Kogyo Co., Ltd as the resist material.

Then, the glass substrate is dipped in an aqueous solution (25°C) of iron chloride to remove the plated film not covered by the resist layer and to form the source electrode and the drain electrode. The distance between the source electrode and the drain electrode (channel length L) is 20 µm, and the channel width W is 1 mm.

After removing the resist layer using the resist remover, the glass substrate with the source electrode and the drain electrode formed thereon is sequentially washed with water and methanol. Then, an oxygen plasma process at atmospheric pressure is conducted on the substrate with the source electrode and the drain electrode formed thereon, using an RF power of 0.05 W/cm² and a flow rate of 80 sccm.

Subsequently, a 1% (w/v) toluene solution of F8T2 (fluorene-bithiophene copolymer) is spin coated (2400 rpm) on the glass substrate and dried at 60°C for 10 minutes. Thus, an organic semiconductor layer with an average thickness of 50 nm is formed. Then, a 5% (w/v) butyl acetate solution of polymethylmethacrylate (PMMA) is spin coated (2400 rpm) on the organic semiconductor layer and dried at 60°C for 10 minutes. Further, a 2% (w/v) isopropyl alcohol solution of polyvinylphenol is spin coated (2400 rpm) thereon and dried at 60°C for 10 minutes. Thus, the gate-insulating layer with an average thickness of 500 nm is formed.

Then, a water dispersion (viscosity of 5 cps at room temperature) of PEDOT (poly-ethylenedioxythiophene) is coated on the gate-insulating layer in an area corresponding to the region between the source electrode and the drain electrode by an ink-jet process (20 pL droplets), and then dried at 80°C for 10 minutes. Thus, the gate electrode with an average thickness of 100 nm is formed.

Through the steps described above a thin film transistor as shown in FIGS. 1A and 1B is manufactured.

### Examples 2-9

The thin film transistor shown in FIGS. 1A and 1B is manufactured similarly to the Example 1 while changing the reducing agent, the pH adjuster, and the presence/absence and/or the nature of the plasma process as shown in TABLE 1.

### Example 10

Firstly, a polyimide substrate with a thickness of 35 µm is provided, and washed with water. Subsequently, the polyimide substrate is dipped in an aqueous solution (25°C) including CrO₃ and sulfuric acid for 60 sec., and then dipped in an aqueous solution (25°C) of ammonium sulfite hydrate for 60 sec. as a pre-process.

Then, a resist layer having a pattern corresponding to the area other than the area, in which the source electrode and the drain electrode are to be formed, is formed on the polyimide substrate by a lithography process, using "PMERP-NZ30" produced by Tokyo Ohka Kogyo Co., Ltd. as the resist material. Then, the plated film is formed as in Example 1.

Thee distance between the source electrode and the drain electrode (channel length L) is 20 µm, and the channel width W is 1 mm.

After removing the resist layer using the resist remover, the polyimide substrate with the source electrode and the drain electrode formed thereon is sequentially washed with water and methanol. Then, an oxygen plasma process under atmospheric pressure is conducted as in Example 1. Subsequently, the organic semiconductor layer, the gate-insulating layer, and the gate electrode are respectively formed on the polyimide substrate as in Example 1.

Through the steps described above a thin film transistor as shown in FIGS. 1A and 1B is manufactured.

### Example 11

After providing the source electrode, the drain electrode, the organic semiconductor layer, and the gate-insulating layer in similar manner as in Example 1, a water dispersion (viscosity of 6 cps at room temperature) of Ag fine particles is coated on the gate-insulating layer in an area corresponding to the region between the source electrode and the drain electrode by an ink-jet process (20 pL droplets), and then calcined in the atmosphere at 120°C for 60 min. Thus, the gate electrode with an average thickness of 800 nm is formed.

### (Example 12)

After forming the source electrode and the drain electrode similarly to the example 1, a 1% (w/v) toluene solution of polyarylamine is spin coated and then dried on a hotplate. Thus, the organic semiconductor layer with an average thickness of 50 nm is formed. Then, a 5% (w/v) butyl acetate solution of polymethylmethacrylate (PMMA) is spin coated (2400 rpm) on the organic semiconductor layer and then dried at 60°C for 10 min. Further, a 2% (w/v) isopropyl alcohol solution of polyvinylphenol is spin coated (2400 rpm) thereon and then dried at 60°C for 10 min. Thus, the gate-insulating layer with an average thickness of 500 nm is formed.

Subsequently, a water dispersion (viscosity of 5 cps at room temperature) of PEDOT (poly-ethylenedioxythiophene) is coated on the gate-insulating layer in an area corresponding to the region between the source electrode and the drain electrode by an ink-jet process (20 pL droplets), and then dried at 80°C for 10 min. Thus, the gate electrode with an average thickness of 100 nm is formed.

Through the steps described above a thin film transistor as shown in FIGS. 1A and 1B is manufactured.

**TABLE 1**

| | Reducing agent | pH adjuster | Plasma process (pressure/gas) |
|---|---|---|---|
| Ex. 1 | Hydrazine | AS ¹⁾ | atmospheric/oxygen |
| Ex. 2 | AH ²⁾ | AS | atmospheric/oxygen |
| Ex. 3 | Hydrazine + AH ³⁾ | AS | atmospheric/oxygen |
| Ex. 4 | Hydrazine | Ammonia water | atmospheric/oxygen |
| Ex. 5 | Hydrazine | TAH ⁴⁾ | atmospheric/oxygen |
| Ex. 6 | Hydrazine | AS + TAH ⁵⁾ | atmospheric/oxygen |
| Ex. 7 | Hydrazine | AS | atmospheric/argon |
| Ex. 8 | Hydrazine | AS | atmospheric/CF₄ |
| Ex. 7 | Hydrazine | AS | None |
| Ex. 8 | AH | AS | None |
| Ex. 9 | Hydrazine + SH ^{6),} ⁷⁾ | AS | atmospheric/oxygen |
| Ex. 10 | Hydrazine | AS | atmospheric/oxygen |
| Ex. 11 | Hydrazine | AS | atmospheric/oxygen |
| Ex. 12 | Hydrazine | AS | atmospheric/oxygen |

| | | | |
|---|---|---|---|
| 1): AS = ammonium sulfide | | | |
| 2): AH = ammonium hypophosphite | | | |
| 3): hydrazine:AH = 60:40 (weight ratio) | | | |
| 4): TAH = trimethyl ammonium hydride | | | |
| 5): ammonium sulfide:TAH = 70:30 (weight ratio) | | | |
| 6): SH = sodium hypophosphite | | | |
| 7): Hydrazine:SH = 90:10 (weight ratio) | | | |

### 2. Evaluation

The threshold voltage, the drain current value at a gate voltage value of -40V, and the S value of each thin film transistor manufactured in the respective examples are measured.

The threshold voltage denotes a gate voltage value when the value of the approximate expression (relational expression) expressing the relationship between the gate voltage and Id^{1/2} (Id: drain current value) makes zero, which can be assumed as a gate voltage value necessary for the drain current to start flowing. Further, the S value denotes a gate voltage value necessary for the drain current value to increase as much as one digit.

Therefore, a thin film transistor with a lower absolute value of the threshold voltage, a larger drain current value at a gate voltage value of -40V, and a smaller S value is a thin film transistor with better characteristics. The measured values are shown in TABLE 2.

**TABLE 2**

| | Threshold voltage [V] | Drain current [A] | S value [V/dec] |
|---|---|---|---|
| Example 1 | -2 | 8 x 10⁻⁷ | 1.5 |
| Example 2 | -1 | 8 x 10⁻⁷ | 1.1 |
| Example 3 | -2 | 8 x 10⁻⁷ | 1.3 |
| Example 4 | -3 | 6 x 10⁻⁷ | 1.7 |
| Example 5 | -2 | 7 x 10⁻⁷ | 1.4 |
| Example 6 | -2 | 8 x 10⁻⁷ | 1.3 |
| Example 7 | -2 | 8 x 10⁻⁷ | 1.2 |
| Example 8 | -3 | 8 x 10⁻⁷ | 1.4 |
| Example 7 | -5 | 2 x 10⁻⁷ | 3 |
| Example 8 | -4 | 2 x 10⁻⁷ | 3 |
| Example 9 | -4 | 2 x 10⁻⁷ | 2.5 |
| Example 10 | -1 | 8 x 10⁻⁷ | 1.2 |
| Example 11 | -2 | 8 x 10⁻⁷ | 1.5 |
| Example 12 | 0 | 5 x 10⁻⁷ | 4.1 |

As shown in TABLE 2, all of the thin film transistors manufactured in the above examples have small absolute threshold voltage values, small S values, and large drain current values, and accordingly superior characteristics.

In particular, the tendency is shown that the characteristics are improved by using the plating solution free of any sodium ions or by executing a plasma process on an electrode.

It may be noted that if the thin film transistor shown in FIGS. 1A and 1B is manufactured similarly to the above examples while changing the nature of gases or using a plurality of kinds of gases in the plasma process, and then similarly evaluated, the same results as of the above examples can be obtained.

Further, if the thin film transistor shown in FIGS. 6A and 6B is manufactured and then evaluated as in the above examples, the same results as of the above examples can be obtained.

## Claims

1. A method of manufacturing a thin film transistor, comprising the steps of:
(a) forming a source electrode and a drain electrode on a substrate by an electroless plating process;
(b) forming an organic semiconductor layer in at least an area between the source electrode and the drain electrode using a coating method;
(c) forming a gate-insulating layer on the organic semiconductor layer using a coating method; and
(d) forming a gate electrode using a coating method so as to overlap an area on the gate-insulating layer and between the source electrode and the drain electrode.

2. The method of Claim 1, wherein, in the step (a), the source electrode and the drain electrode are selectively formed by providing an electroless plating solution inside an opening of a mask provided on the substrate.

3. The method of Claim 2, wherein the electroless plating solution is substantially free of alkali metal ions.

4. The method of Claim 3, wherein both of the source electrode and the drain electrode are formed like comb-teeth and arranged to engage with each other.

5. The method of any of Claims 1-4, wherein each of the source electrode and the drain electrode is composed mainly of one ofNi, Cu, Pd, Au, Pt, and an alloy including one ofNi, Cu, Pd, Au, and Pt.

6. The method of any of Claims 1-5, further comprising prior to the step (b):
removing any organic matter existing on the side of the substrate surface where the organic semiconductor layer is to be formed.

7. The method of Claim 6, wherein the organic matter is removed by a plasma process.

8. The method Claim 7, wherein the plasma process is executed under the atmospheric pressure.

9. The method of Claim 7 or 8, wherein the plasma is generated using a gas composed mainly of at least one of oxygen, nitrogen, argon, helium, and fluorocarbon.

10. The method of any of Claims 1-9, wherein the organic semiconductor layer is mainly composed of a conjugated polymeric material.

11. The method of Claim 10, wherein the conjugated polymeric material is mainly composed of at least one of fluorene-bithiophene copolymer, polyarylamine, and derivatives thereof.

12. The method of any of Claims 1-11, wherein the coating method used for forming the gate electrode in the step (d) is an inkjet method.

13. The method of any of Claims 1-12, wherein the gate electrode is mainly composed of an electrically conductive polymeric material.

14. The method any of Claims 1-12, wherein the gate electrode is formed using a fluid including metal particles.

15. The method of Claim 14, wherein the metal particles are mainly composed of Ag.

16. The method of any of Claims 1-15, wherein the substrate mainly composed of a resin material, and the method further comprises prior to step (a):
conducting on the surface of the resin substrate where the source electrode and the drain electrode are to be formed a process for enhancing the adhesiveness with the source electrode and the drain electrode.

17. The method of Claim 16, wherein the adhesiveness enhancing process comprises:
etching the surface of the resin substrate with an etching fluid including a transition metal oxide and an inorganic acid; and
treating the surface of the resin substrate with a fluid including a reducing agent substantially free of an alkali metal element.

18. The method of Claim 17, wherein the reducing agent is mainly composed of an ammonium compound.

19. The method of Claim 18, wherein the ammonium compound is ammonium sulfite hydrate.

20. A thin film transistor obtainable by the method of any of Claims 1-19.

21. A thin film transistor circuit comprising the thin film transistor of Claim 20.

22. An electronic device comprising the thin film transistor circuit of Claim 21.

23. An electronic apparatus comprising the electronic device of Claim 22.
